# EUROPEAN PATENT APPLICATION

(11) **EP 1 447 838 A2**
(43) Date of publication of application: **18.08.2004**
(21) Application number: 04002962.1
(22) Date of filing: 10.02.2004
(51) Int. Cl.: H01L 21/00, H02N 15/00, G03F 9/00

(54) **System and method to reduce the effect of reactive forces on a stage using a balance mass**

(30) Priority: 14.02.2003 US 366444
(71) Applicant: ASML Holding N.V., 5504 DR Veldhoven (NL)
(72) Inventor: Carter, Frederick Michael, Connectut 06776 (US); Stenabaugh, Donald, New Milford Connecticut 06776 (US)
(74) Representative: Grünecker, Kinkeldey, Stockmair & Schwanhäusser Anwaltssozietät

(57) **Abstract**

A system and method are used to levitate and translate a stage within a chamber using a motor assembly coupled to a balance mass assembly. The balance mass assembly is positioned adjacent the chamber. The motor assembly includes a stator and a coil. One of the stator and the coil are coupled to the stage on a first side of a wall of the chamber. The other of the stator and the coil are coupled to the balance mass assembly on a second side of the wall of the chamber. A magnetic assembly coupled to the stage allows the stage to levitate within the chamber. Once levitated, the stage is translated based on the interaction of the magnets and an energized coil.

## Description

### BACKGROUND OF THE INVENTION

### Field of the Invention

The present invention is related to lithography and more specifically to the positioning of lithographic stages within a lithographic system.

### Background Art

Lithography is a process used to create features on the surface of substrates. Such substrates can include those used in the manufacture of flat panel displays, circuit boards, various integrated circuits, and the like. A frequently used substrate for such applications is a semiconductor wafer. While this description is written in terms of a semiconductor wafer for illustrative purposes, one skilled in the art would recognize that this description also applies to other types of substrates known to those skilled in the art. During lithography, a wafer, which is disposed on a wafer stage, is exposed to an image projected onto the surface of the wafer by exposure optics located within a lithography apparatus. While exposure optics are used in the case of photolithography, a different type of exposure apparatus can be used depending on the particular application. For example, x-ray, ion, electron, or photon lithographies each can require a different exposure apparatus, as is known to those skilled in the art. The particular example of photolithography is discussed here for illustrative purposes only.

The projected image produces changes in the characteristics of a layer, for example photoresist, deposited on the surface of the wafer. These changes correspond to the features projected onto the wafer during exposure. Subsequent to exposure, the layer can be etched to produce a patterned layer. The pattern corresponds to those features projected onto the wafer during exposure. This patterned layer is then used to remove or further process exposed portions of underlying structural layers within the wafer, such as conductive, semiconductive, or insulative layers. This process is then repeated, together with other steps, until the desired features have been formed on the surface, or in various layers, of the wafer.

Step-and-scan technology works in conjunction with a projection optics system that has a narrow imaging slot. Rather than expose the entire wafer at one time, individual fields are scanned onto the wafer one at a time. This is done by moving the wafer and reticle simultaneously such that the imaging slot is moved across the field during the scan. The wafer stage must then be asynchronously stepped between field exposures to allow multiple copies of the reticle pattern to be exposed over the wafer surface. In this manner, the quality of the image projected onto the wafer is maximized.

Conventional lithographic systems and methods form images on a semiconductor wafer. The system typically has a lithographic chamber that is designed to contain an apparatus that performs the process of image formation on the semiconductor wafer. The chamber can be designed to have different grades of vacuum depending on the wavelength of light being used. A reticle is positioned inside the chamber. A beam of light is passed from an illumination source (located outside the system) through an optical system, through an image outline on the reticle, and a second optical system before interacting with a semiconductor wafer.

The reticle can be placed on a platform or stage (hereinafter, both are referred to as "stage"). The stage can be translated according to parameters of the lithographic system. Similarly, the semiconductor wafer can be placed on a stage. The stage supporting either the reticle or the semiconductor wafer can be translated in one or more directions and/or one or more degrees of freedom depending on how the image is to be formed on the semiconductor wafer. In either case, the stages can be translated using a variety of electromagnetic motors, such as linear motors, Lorentz motors, reluctance motors and the like. The linear motor typically includes of a stator and motor coils. An example of a linear motor used in lithography can be found in U.S. Patent No. 6,271,606 to Hazelton, which is incorporated by reference herein in its entirety. Interaction between the stator and the linear motor coils causes the movement of the stages. However, such movement produces a set of reaction forces that offsets the precise movement of the stages. The reaction forces are caused by the operation of the electromagnetic motor and the power/control cables supplying power to the electromagnetic motor. The power/control cables cause vibrations that go through the system using the electromagnetic motor. This creates an offset error when the stage is translated. The offset error can cause improper image formation on the semiconductor wafer. Therefore, what is needed is a system and method that can significantly reduce or eliminate the effect produced by the reaction forces.

With conventional electromagnetic motors, the lithographic stage can be levitated using air bearings or motors. However, conventional electromagnetic motors and contact bearings cause friction between components, which can lead to particles that contaminate the environment surrounding the stage. Therefore, there is also a need for a system and method for moving stages in lithographic systems that reduces or eliminates contamination from the environment surrounding the stages.

### BRIEF SUMMARY OF THE INVENTION

Embodiments of the present invention provide a method including (a) positioning one of a stator or a coil on one side of a wall of a chamber and coupled to a balance mass assembly, (b) positioning the other of the stator or the coil on an opposite side of the wall of the chamber and coupled to a stage, (c) levitating the stage, (d) applying power to the coil to translate the stage based on a magnetic interaction of the coil and the stator, and (e) counteracting reactive forces caused by the translation using the balance mass assembly.

Embodiments of the present invention provide a system including a chamber, a stage located inside the chamber, a balance mass assembly positioned adjacent the chamber, and a motor assembly including a stator and a coil. One of the stator and the coil being coupled to the stage on a first side of a wall of the chamber and another one of the stator and the coil being coupled to the balance mass assembly on a second side of the wall of the chamber.

Embodiments of the present invention are directed towards systems and methods for positioning a stage within a lithography system. The system can include a chamber having a stage inside and a motor assembly having a stator coupled to a balance mass (e.g., a mass that can be used to reduce or eliminate reactive forces) and a coil. The stator also includes a magnet that generates a magnetic field, which interacts with the electric field generated by the coil assembly, so as to move the stage. The chamber can be a vacuum or a non-vacuum chamber. The coil assembly can be positioned inside the chamber and coupled to the stage. The coil assembly can be located adjacent to the balance mass, but separated from the balance mass by a wall of the chamber. Placing the coil assembly within the chamber allows the vacuum to be maintained, thus reducing contamination.

In another embodiment, the stator having the balance mass can be located inside the chamber and the coil assembly can be located outside the chamber.

Still other embodiments of the present invention have various locations of the balance mass, the stator, and the coil assembly with respect to the chamber and each other.

In one aspect of the present invention, the stator can be positioned on non-contact bearings. The non-contact bearings system can include an assembly of magnets. A first set of magnets or rails can be mounted on a base coupled to the wall of the chamber and a second set of magnets can be mounted on the stage. Such bearings can be air bearings, magnetic bearings, or the like. These bearings allow smoother translations of the stage and allow the balance mass to absorb reaction forces generated by the motion of the stage.

In one aspect of the present invention, the stage can be positioned on a system of non-contact bearings. The bearings can be air bearings, magnetic bearings, or the like. The non-contact bearings system allows smoother and more precise translations between desired stage positions.

In one aspect of the present invention, the coils located within the chamber can be placed in a cavity within the stator. The cavity has various shapes and sizes, such as an elliptical or round shape. The shape of the cavity can be used to withstand the pressure of the chamber's environment.

Further embodiments, features, and advantages of the present inventions, as well as the structure and operation of the various embodiments of the present invention, are described in detail below with reference to the accompanying drawings.

### BRIEF DESCRIPTION OF THE DRAWINGS/FIGURES

The accompanying drawings, which are incorporated herein and form part of the specification, illustrate the present invention and, together with the description, further serve to explain the principles of the invention and to enable a person skilled in the relevant art(s) to make and use the invention.

FIG. 1 is a block diagram of a lithography system according to the embodiments of the present invention.

FIG. 2 shows a section of the lithographic system in FIG. 1 according to embodiments of the present invention.

FIG. 3 shows a portion of the section of the lithographic system in FIG. 2 according to an embodiment of the present invention.

FIG. 4 shows a portion of the section of the lithographic system in FIG. 2 according to an embodiment of the present invention.

FIG. 5 shows a flowchart depicting a method according to an embodiment of the present invention.

The present invention is described with reference to the accompanying drawings. In the drawings, like reference numbers can indicate identical or functionally similar elements. Additionally, the leftmost digit of a reference number usually identifies the drawing in which the reference number first appears.

### DETAILED DESCRIPTION OF THE INVENTION

### Overall System

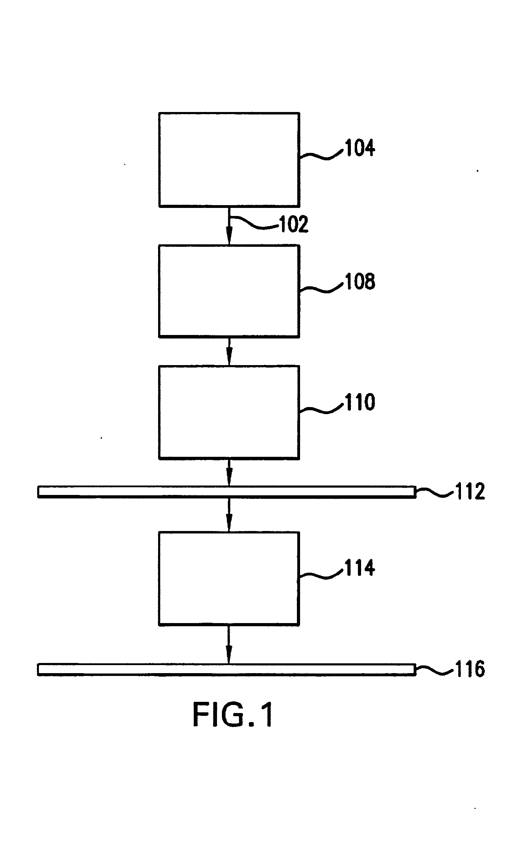

FIG. 1 shows a system 100 according to an embodiment of the present invention. One embodiment for system 100 can be a lithography system, or the like. Light 102 is emitted from a laser 104 (e.g., an exciter laser, deep UV excimer laser, or the like). The light 102 is received by a beam conditioner 108 that outputs light to illumination optics 110. Illumination optics 110 transmit the light through reticle (or mask) 112 onto a substrate (or wafer) 116 via projection optics 114.

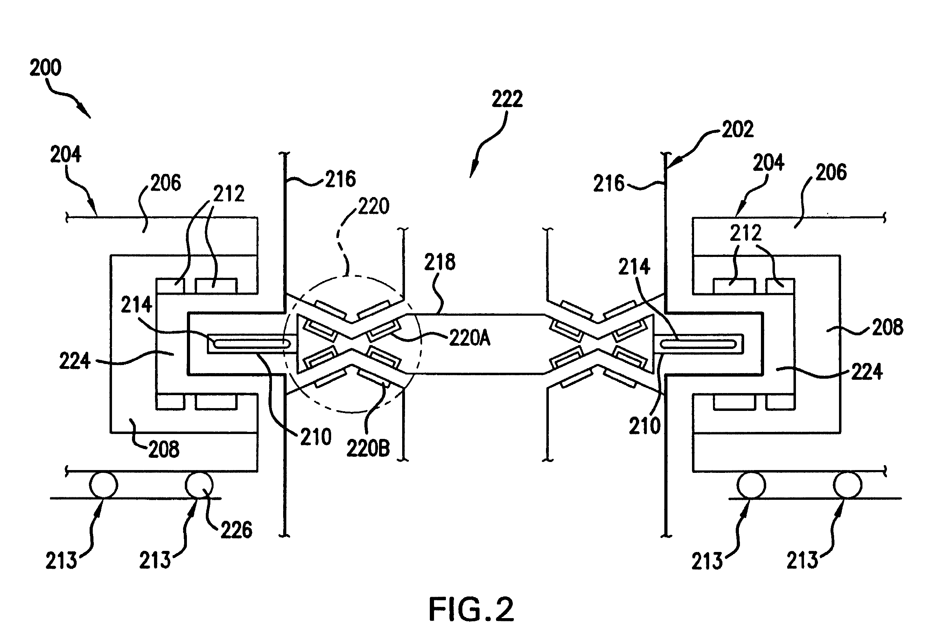

FIG. 2 shows a section 200 of system 100 according to embodiments of the present invention. Section 200 includes a chamber 202 adjacent to a balance mass assembly 204. Balance mass assembly 204 includes a balance mass 206 coupled to a stator 208 of a motor assembly. The motor assembly also includes a coil 210. Stator 208 includes magnets 212 that interact with a conductors 214 in coil 210 through a wall (e.g., vacuum wall) 216 when the motor assembly is in operation. Stator 208 can be placed on a non-contact bearings system 213.

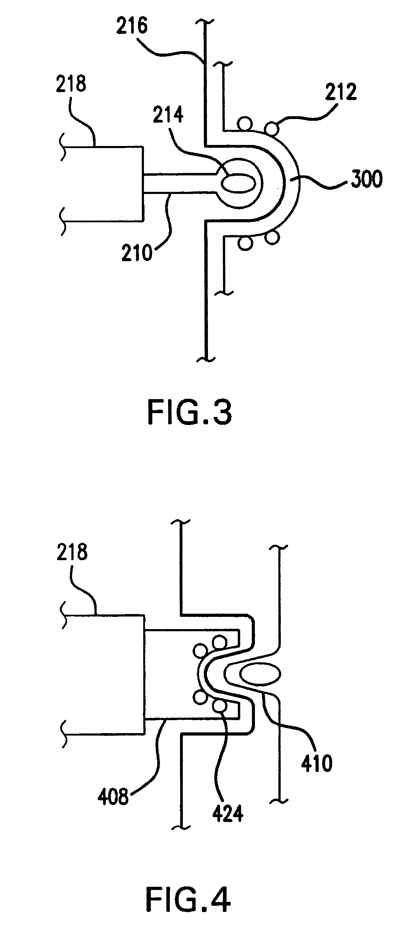

It is to be appreciated that in various embodiments, the location of stator 208 and coil 210 can reversed, where coil 210 is placed outside of chamber 202 and coupled to balance mass 206 and stator 208 is placed inside chamber 202 and coupled to a stage 218. An examples of this is shown in FIG. 4, described in more detail below.

With continuing reference to FIG. 2, chamber 210 includes a stage 218 coupled to coil 210. Stage 218 can be coupled to magnet assemblies 220, which are used to translate stage 218 within chamber 210. Magnet assemblies 220 include magnets 220A and rails 220B. In the embodiment shown, magnets 220A are integral with stage 218 and rails 220B are integral with a section 221 of chamber 202. In other embodiments this can be reversed. It is to be appreciated that adjacent magnets 220A can be at any angle with respect to each other, preferably between 0 and 90 degrees. Once magnet assembly 220 is energized, as shown in FIG. 2, magnets 220A and rails 220B separate, such that stage 218 levitates between sections 221.

A thickness of wall 216 can be designed so that wall 216 operates as a separator between an inside area 222 of chamber 202 and stator 208. The thickness of wall 216 should be designed so that stator 208 magnetically interacts with coil 210 through wall 216 during translation of stage 218. Thus, the thicker wall 216 becomes the less powerful the magnetic interactions are between magnets 212 and conductors 214. In some embodiments, the thickness can vary in different areas of wall 216. It is to be appreciated that equal thickness wall portions are contemplated by the present invention. It is also to be appreciated that the thickness of wall 216 is application specific because the specific thickness can depend on the pressure differential across wall 216. In most embodiments, wall 216 can be electrically non-conductive, which allows interactions between magnets 212 and conductor 214. For example, wall 216 can be manufactured from plastic or other composite material that is non-conductive. In other embodiments, a non-magnetic material such as aluminum can be used. In a preferred embodiment, wall 216 is non-magnetic and non-conductive.

The motor assembly can also include a cavity 224 that is configured to receive coil 210. A size of cavity 224 is defined at least by a size of coil 210. Cavity 224 can also be sized to fit wall 216 that encloses coil 210. Cavity 224 is designed so that there is an improved magnetic interaction between stator 208 and coil 210. Cavity 224 can have a variety of shapes and sizes, such as rectangular, round, elliptical, pentagonal, or the like, as seen in FIGS. 2-4. A length of cavity 224 can be equal to a length of chamber 202 or equal to a maximum distance that stage 218 translates in a direction into the paper.

Balance mass 206 can be used to balance reaction forces that are generated by the translation of stage 218. During translation of stage 218, reaction forces are generated and transferred to the motor assembly. The addition of balance mass 206 absorbs reaction forces generated during translation, which helps to correct errors in translation of stage 218.

As discussed above, balance mass assembly 204 can be placed on a non-contact bearings assembly 213. Non-contact bearings assembly 213 can include a pair of non-contact bearing devices 226. Non-contact bearing devices 226 can levitate balance mass assembly 204 when system 200 is operational. In various embodiment, non-contact bearings system 213 can be configured as a non-contact an air bearings system or a non-contact magnetic bearings system. The air or magnetic bearings system 213 can include air bearings or magnetic bearings 226, respectively, that support balance mass assembly 204 while the motor assembly translates stage 218 inside chamber 202. By placing balance mass assembly 204 on air bearings and by coupling balance mass 206 to stator 208, the effects of reaction forces generated by the translation motion are reduced or eliminated except for air bearing friction or cables.

Thus, the motor assembly can translate stage 218 without any contact with balance mass assembly 204. This is accomplished through magnetic interaction between stator 208 and coil 210. Magnets 212 and conductors (e.g., electromagnetic coils) 214 interact through wall 216 when system 200 is operational. Since, coil 208 is positioned inside cavity 224, such interaction does not affect movement of stage 218. It is to be appreciated that magnets 214 can be placed so that there is least interference with the magnetic interaction between magnets 214 and electromagnetic coils 214.

Turning now to area 222, in one embodiment area 222 can be vacuum. If area 222 is vacuum, then translations of stage 218 can be contamination free. This means that a number of contaminating particles produced as a result of any friction between components of system 200 can be substantially reduced. In another embodiment, area 222 can be filled with a gaseous substance. However, the amount of contamination particles produced during translations of stage assembly can increase.

It is to be appreciated that a size of balance mass 206 is application specific. Therefore, if large reaction forces are produced during translation of stage 218, then the size of balance mass 206 can be increased accordingly to reduce the effect of reaction forces. Similarly, if the effect produced by reaction force is relatively small, then a smaller balance mass 206 can be used. It is also to be appreciated that the weight of balance mass 206 and the weight of stage218 can determine the length of travel of balance mass 206.

FIG. 3 shows a cavity 300 having a circular or round shape according to an embodiment of the present invention. Accordingly, coil 210 also has a circular or round shape in order to be received by cavity 224.

FIG. 4 shows an alternative configuration for system 200 according to embodiments of the present invention. In this configuration, as discussed above, magnet 408 is coupled to stage 218 and coil 410 is coupled to balance mass assembly 404. Also, magnet 408 has a elliptical cavity 424 inside chamber 402. Cavity 424 receives an elliptically shaped coil 410.

It is to be appreciated that any number of configurations can be used for the stator, magnets, coil, and/or conductor. All are contemplated within the scope of the present invention.

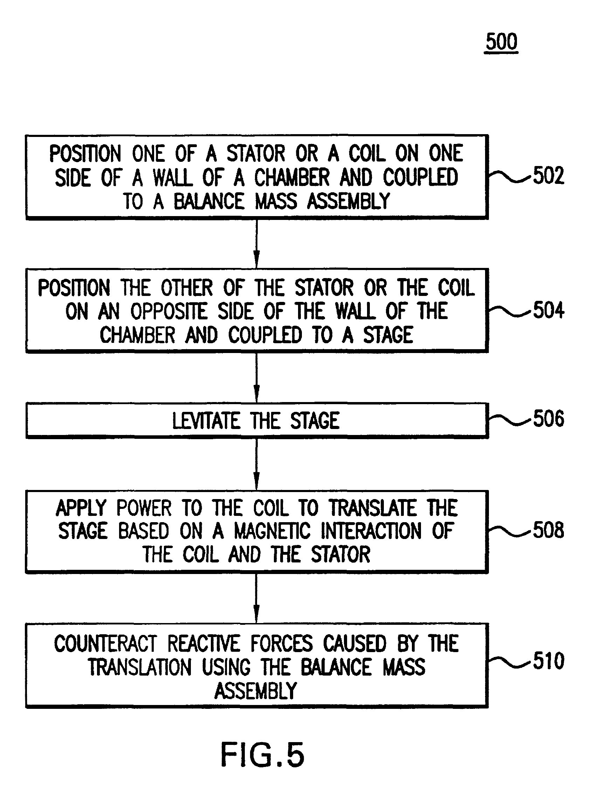

FIGS. 5 shows a flowchart depicting a method 500 according to embodiments of the present invention. In step 502, one of a stator or a coil is positioned on one side of a wall of a chamber and coupled to a balance mass assembly. In step 504, the other of the stator or the coil is positioned on an opposite side of the wall of the chamber and coupled to a stage. In step 506, the stage is levitated. In step 508, power is applied to the coil to translate the stage based on a magnetic interaction of the coil and the stator. In step 510, reactive forces are counteracted that are caused by the translation using the balance mass assembly.

### Conclusion

Example embodiments of the methods, circuits, and components of the present invention have been described herein. As noted elsewhere, these example embodiments have been described for illustrative purposes only, and are not limiting. Other embodiments are possible and are covered by the invention. Such embodiments will be apparent to persons skilled in the relevant art(s) based on the teachings contained herein. Thus, the breadth and scope of the present invention should not be limited by any of the above-described exemplary embodiments, but should be defined only in accordance with the following claims and their equivalents.

## Claims

1. A system comprising:
a chamber;
a stage located inside the chamber;
a balance mass assembly positioned adjacent the chamber; and
a motor assembly including a stator and a coil, one of the stator and the coil being coupled to the stage on a first side of a wall of the chamber and another one of the stator and the coil being coupled to the balance mass assembly adjacent a second side of the wall of the chamber.

2. The system of claim 1, wherein:
the coil is coupled to the stage; and
the stator is coupled to a balance mass in the balance mass assembly.

3. The system of claim 1, wherein:
the stator is coupled to the stage; and
the coil is coupled to a balance mass in the balance mass assembly.

4. The system of claim 1, further comprising a magnetic assembly magnetically coupled to the stage configured to levitate the stage when the magnetic assembly is energized.

5. The system of claim 1, further comprising a non-contacts bearings assembly coupled to the balance mass assembly.

6. The system of claim 5, wherein the non-contact bearings assembly is a air-bearings assembly.

7. The system of claim 5, wherein the non-contact bearings assembly is a magnetic bearings assembly.

8. The system of claim 1, wherein the chamber is a vacuum chamber.

9. The system of claim 1, wherein the chamber is a gaseous chamber.

10. The system of claim 1, wherein the wall of the chamber is rectangular.

11. The system of claim 10, wherein the coil is rectangular.

12. The system of claim 1, wherein the wall of the chamber is round.

13. The system of claim 12, wherein an end of the coil is round.

14. The system of claim 1, wherein the wall of the chamber is elliptical.

15. The system of claim 1, wherein the coil and at least a section of the wall have a same shape.

16. A method comprising:
(a) positioning one of a stator or a coil on one side of a wall of a chamber and coupled to a balance mass assembly;
(b) positioning the other of the stator or the coil on an opposite side of the wall of the chamber and coupled to a stage;
(c) levitating the stage;
(d) applying power to the coil to translate the stage based on a magnetic interaction of the coil and the stator; and
(e) counteracting reactive forces caused by the translation using the balance mass assembly.
